# EUROPEAN PATENT SPECIFICATION

(11) **EP 1 828 434 B1**
(45) Date of publication and mention of the grant of the patent: **16.01.2008**
(21) Application number: 04765264.9
(22) Date of filing: 16.09.2004
(51) Int. Cl.: C23C 18/18, H05K 3/38, B29C 59/14

(54) **METHOD FOR IMPROVING THE ELECTRICAL CONNECTION PROPERTIES OF THE SURFACE OF A PRODUCT MADE FROM A POLYMER-MATRIX COMPOSITE**
VERFAHREN ZUR VERBESSERUNG DER ELEKTRISCHEN VERBINDUNGSEIGENSCHAFTEN DER OBERFLÄCHE EINES PRODUKTS AUS EINEM POLYMER-MATRIX-VERBUNDWERKSTOFF
PROCEDE PERMETTANT D'AMELIORER LES PROPRIETES DE CONNEXION ELECTRIQUE DE LA SURFACE D'UN PRODUIT CONÇU DANS UN COMPOSITE A MATRICE POLYMERIQUE

(43) Date of publication of application: 05.09.2007
(73) Proprietor: Kolektor Group d.o.o., 5280 Idrija (SI)
(72) Inventor: CVELBAR, Uros, SI-4280 Idrija (SI); MOZETIC, Miran, SI-1000 Ljubljana (SI)
(74) Representative: Grättinger & Partner (GbR)
(86) International application number: PCT/EP2004/010362
(87) International publication number: WO 2006/029642

(56) References cited:
- EP-A- 0 475 145
- US-A- 4 597 828

## Description

The present invention relates to a method for improving the electrical connection properties of the surface of a product made from a polymer-matrix composite comprising a filler.

Traditional materials are being gradually substituted with polymer-matrix composites comprising a filler. Composite in this sense is any material made of one or more polymers with fillings dispersed inside the polymer, suitable fillings being e.g. particles made from graphite, amorphous hydrogenated carbon, diamond or diamond-like carbon, glassy carbon, soot, fullerene, nanotubes, nanowires and the like of any size or shape. Also the products made from such composites can be of any size or shape including plates, spheres, wires etc.

Promising substitutes for metals are polymer-matrix composites. They are characterized by a low weight, good electrical, thermal and mechanical properties, and excellent chemical resistance. The major drawback of polymer-matrix composites are, however, poor electrical connection properties, i.e. poor affinity of any surface metallization and/or directly applied metal connection means (e.g. solder) to the surface.

It is understood that this is caused among others by a poor wettability of the surface which results among others from the evenness of the surface and low surface tension of products made from polymer matrix composites.

To improve wettability of polymer-matrix composites for solder, surface etching is performed by traditional methods such as wet chemical etching. The typical case is treating superconducting composites surface as described in US 6214249 and WO 02/071462. The wet chemical etching is also used to improve metal plating of composites (US 6080836).

The modification of a polymer layer done by oxidation with the flame, corona discharge or chemical-etching agents is also used for preparing metal-polymer composites (M. Mozetic et al, Materials Science Forum Vols. 437-438 (2003) 81-84.). The method that relates to adhesive bonding of metals to vinyl chloride-containing polymers is described in US 3833458. The method is used for mechanical fastening devices such as bolts and clamps.

Novel etching methods have been applied in one or more steps for producing integrated circuit devices. Typically, the innovations such as US 2002/055263, US 5705428 and US 2002/125207 are dealing with plasma processing methods for etching semiconductor samples such as wafers with a high frequency discharge.

Further it has been shown that it is possible to increase the surface roughness of graphite/polymer composites by oxygen plasma treatment (U. Cvelbar et al., "Increased Surface Roughness by Oxygen Plasma Treatment of Graphite/Polymer Composite" in Applied Surface Science 210 (2003), 255-261).

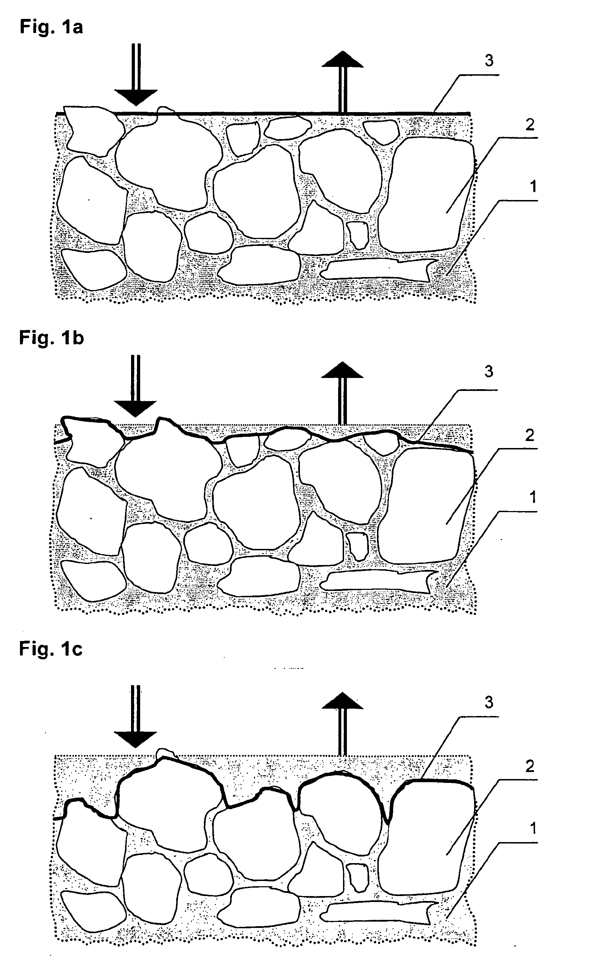

Non-equilibrium states of gases such as those used in the above referenced document have been produced for decades. The most common method for producing a highly non-equilibrium gas is by passing gaseous molecules through a discharge. Molecules are excited, dissociated and ionized at inelastic collisions with energetic particles (mainly electrons and metastable atoms). Excited, atomized and ionized molecules will be called radicals. The concentration of radicals depends on discharge parameters and may approach unity. Although, the kinetic temperature of neutral gas is close to room temperature, the average internal energy of radicals can be more than 1 eV, corresponding to the internal temperature exceeding 10.000°C. Due to poor energy exchange, the extremely high radicals temperature is benign to composites, but the radicals readily interact chemically on the surface of polymer-matrix composites. [Fig.1a]

To promote adhesion to polyethylene (UHMPE) fiber/vinyl ester resin composites, the plasma etching as one of the steps in fabrication of polymer fibers is described in US 5221431. The method of this disclosure comprises subjecting a fabric made from polyethylene fibers to plasma etching, applying a silane coupling agent to etched fabric, and impregnation the fabric with vinyl ester resins, followed by conventional molding.

For wide use in medicine and industry the method for producing stable atmospheric pressure glow discharge plasmas have been patented (US 2001/000206, US 5928527 and US 614249). This atmospheric pressure plasma is also used for modifying surface layers of materials.

Whereas there are some promising results in the plasma surface treatment of filled polymer-matrix composites, adhesion of a surface metallization and/or metal connecting means to the surface is not satisfactory under all conditions, resulting in that it is difficult to provide for a reliable electric connection of such composites to adjacent components.

Therefore the present invention aims at improving the capabilities of a product made from a filled polymer-matrix composite with regard to electrical connection to adjacent components while providing a simple method for this purpose at low costs.

This object is achieved by a method as defined in claim 1. Accordingly it is an essential aspect of the present invention to have a several-step oxygen plasma surface treatment under specific temperature conditions for the individual plasma treatment steps as set out in claim 1. In detail there is first a treatment of the surface of the composite product with radicals at an elevated first treatment temperature which treatment results in a polymer removal and deeper etching of the composite which, among other results, to some extent may lead to an increased surface roughness. Thereafter there is a cooling down of the product with subsequent activation of the thus achieved rough surface by plasma treatment at a reduced second treatment temperature of the product. And finally there is the deposition of a metallization on the thus prepared surface having a good wettability. As a result of application of the present invention, the surface of the product treated in such a way is perfectly prepared for subsequent processing. In particular the surface is not only sufficiently rough for bonding of a metal connecting means such as solder, but also the metallization deposited on the surface after the second plasma treatment perfectly adheres to the surface since the latter has before been effectively activated and remains in this state a sufficient time such that the benefits from surface activation can be effectively exploited in the subsequent processing, i.e. surface metallization.

The said filler in the polymer-matrix composite is preferably sintered carbon or graphite or in another preferred embodiment of the invention a mixture including carbon or graphite.

In another aspect of the invention it can be said that the results aimed at are positively influenced by providing for a weakly ionized highly dissociated plasma in the plasma treatment steps of the inventive method. This means that the space-charge density is below about 10¹⁷m⁻³, preferably below 10¹⁶m⁻³ and the dissociation fraction of gaseous molecules exceeds 10%. If instead of the dissociation fraction the plasma reactivity is to be expressed in terms of density of atomic radicals, a preferred range for the density of the O atoms is above 10²⁰m⁻³, preferably above 10²¹m⁻³.

Further aspects of the present invention as well as preferred embodiments thereof will become apparent from the subsequent description and from the subclaims.

The present invention makes use of the finding that the interaction of radicals with polymer-matrix composites is highly selective: at first, the radicals react primarily with polymer matrix while leaving fillings untouched. Later on, the radicals may interact also with fillings, but the reaction rate with polymer is always higher than with fillings. This effect was explained by Cvelbar et al. with the following considerations.

Samples facing plasmas are always heated due to physical and chemical reactions, but as long as particles on the surface are in good thermal contact with the bulk, the surface temperature is not much higher than the bulk temperature. The uppermost graphite grains are firstly well embedded in polymer matrix and therefore the thermal contact to the bulk material is high enough to prevent their overheating. However, as polymer between the grains is disappearing, the thermal contact is decreasing and the temperature (and therefore also the oxidation) of the grains is increasing. Finally the loosely bonded graphite grains are just burned, leading to an increased roughness of the surface.

This change in surface roughness appears only after about 5 minutes of plasma treatment (see Cvelbar et. al.). By firstly heating the material to an elevated temperature this etching method takes place in a shorter time period and therefore provides a simple and fast method for roughening the surface of a polymer-matrix composite.

Selective interaction of radicals causes selective etching of polymer-matrix composites. At low composite temperature only polymer is etched. At elevated temperature some fillings may be etched as well leading to a fast and dramatic increase of the roughness of the polymer matrix composites. Thus the first oxygen plasma treatment of the inventive method at elevated temperature is directed to preparing a suitable surface roughness within a short time. Also there are additional very beneficial effects such as appearance of fillers (e.g. graphite grains) and formation of polar groups (on the polymer and filler) that raise surface tension breaking bonds of material during etching which effects in combination with each other lead to the good results of the inventive method. In contrast hereto the second plasma treatment of the inventive method, which is performed after the product has been cooled down from the elevated first treatment temperature to a second treatment temperature, is directed primarily to a long-lasting activation of the rough surface received by the first plasma treatment.

Radicals may be incorporated in the surface layer of a composite causing formation of polar functional groups. The appearance of highly polar groups on the composite surface causes an increase of the surface wettability and thus affinity to metallization (M. Mozetic et al.). But this activation of the material tends to deactivate spontaneously. At high temperatures this deactivation takes place very fast. The activation achieved by the first plasma treatment at an elevated temperature has therefore a very small deactivation time and would not last long enough for the following metallization step. Due to the relatively low second treatment temperature the thus achieved activation of the surface remains sufficiently long and such that it can be effectively exploited in the subsequent metallization step for improved adherence of the metallization to the substrate.

There are a number of distinct advantages in the use of the inventive method for treatment of polymer-matrix composites as opposed to classical methods, which currently employ wet chemical surface etching and activation. It enables a good adhesion of a metal layer on the composite surface, it is ecologically benign and its operating costs and maintenance are minimal. In this context it is of some relevance that acceleration of removing the polymer from the surface, which also leads to the appearance of filler-grains at the surface and a more ore less increased roughness of the surface, in the high-temperature first plasma treatment allows for a fairly short first plasma treatment time such that plasma reactors for a given throughput may be fairly small and inexpensive; similarly the costs of the plasma treatment being directly related to the treatment time are relatively low.

The inventive two-step processing with oxygen radicals or any other radicals and subsequent surface metallization can thus be applied for preparing polymer composites of the type in dispute for subsequent electrical connecting to adjacent components, e.g. by soldering. Similarly such process of selective activation and subsequent surface metallization can also be applied for a similar treatment of sintered carbon or graphite. In this case application of the present method leaves the surface free of unbonded or loosely bonded particles with better affinity to metallization and a higher adhesion of the metal coating on the surface of said sintered carbon or graphite.

When performing the method for treatment of polymer-matrix composites according to the present invention, said composites are exposed to a high flux of oxygen radicals. Radicals are usually produced in plasma created in pure oxygen or a mixture of oxygen and another gas (typically argon or any other inert gas) or oxygen containing gas (typically water vapor or hydrogen peroxide). However, radicals can be also produced by any other technique including thermal dissociation and shock-wave excitation. In a preferred embodiment of the inventive method the first and the second plasma treatment are performed in an atmosphere of a mixture of oxygen and at least one noble gas (preferably argon), wherein the oxygen content in the initial atmosphere is between 5 and 95 % by volume.

Other preferred embodiments of the method relate to an optimization of other parameters of the inventive method.

In a preferred embodiment the first elevated treatment temperature is between 20 to 150°C below the softening temperature of the polymer in order to improve the first plasma treatment process of selective etching the surface of the polymer-matrix composite with fillings. Alternatively it could also be between 0.7 and 1 times the softening temperature in Centigrade or, in absolute values and with respect to the most common polymers, between 50 and 500°C or, more preferred, between 80 and 400°C.

As already mentioned, the second treatment temperature is below the first treatment temperature in order to provide a long-lasting activated surface of the polymer-matrix composite. Therefore this temperature is preferably chosen such that the activation time is at least 1 second if not more. In absolute values, this can preferably be achieved, dependent from the treated polymer-matrix composite, with temperatures of less than 150°C, more preferably less than 60°C or even more preferably temperatures in a range between 15 to 45°C or even less.

The time for exposing the surface to the second plasma treatment can be much smaller than the time for exposing the surface to the first plasma treatment. For example the second plasma treatment time may be 0.005 to 0.2 times the first plasma treatment time. In a concrete example with a specific flux of radicals discussed hereafter the first treatment may take 1 to 2 minutes, whereas the second treatment takes only about 10 to 15 seconds.

Whereas, depending on the individual circumstances, this is not indispensable the metallization should preferably be initiated shortly after the second plasma treatment (e.g. within (2) [I would dismiss this number] minutes). However under specific circumstances also initialization of the metallization step hours after termination of the second plasma treatment may lead to good results. This metallization can be performed by making use of any well-known metallization-process, such as a galvanic-process, a PVD-process or a PECVD-process.

Hereafter the present invention is further discussed making reference to the drawings in which
- Fig. 1a: is a sketch illustrative, presenting polymer-matrix composites composed from polymer-matrix and fillings that react with radicals,
- Fig. 1b: is a sketch illustrative, presenting the first stage of selective composite etching - etching of polymer, leaving fillings untouched,
- Fig. 1c: is a sketch illustrative, presenting the second stage of selective composite etching - etching of polymer and some fillings at elevated temperatures, leaving gaps between fillings and rough surface,
- Fig. 1d: is a sketch illustrative, presenting the formation of polar functional groups when radicals are incorporated into etched surface,
- Fig. 2: is a schematic of the system, representing an example of a system intended for selective etching of polymer-matrix composites and subsequent surface activation,
- Fig. 3: is a graph of Talysurf profiles from three different untreated and plasma treated samples showing the increase in surface roughness,
- Fig. 4: is a graph representing the wettability of a deionized water drop on the treated sample surface as a function of the radicals' dose,
- Fig. 5: is a graph representing an adhesion force of the metallized surface as a function of the radicals' dose of plasma treated samples, and
- Fig. 6: is a graph representing an electrical resistivity as a function of the radicals' dose.

### Detailed description of the invention

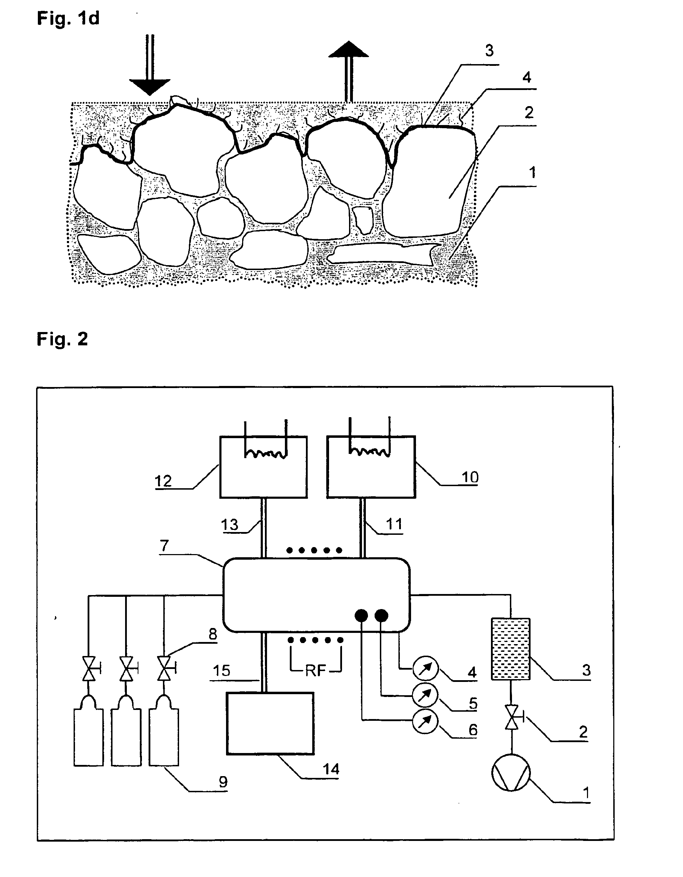

A schematic representation of the method of the present invention is shown in Fig. 1. Polymer-matrix composite is exposed to a flux of oxygen radicals. The radicals react with surface polymer [Fig.1a]. In the first plasma treatment of the surface at an elevated temperature, firstly polymer is etched so that the polymer between the fillings is removed [Fig.1b]. With further exposure to oxygen radicals, the loosely bonded fillings on the surface interact with oxygen radicals causing etching of some uppermost fillings and clusters of fillings. The surface roughness is increased [Fig.1c]. After cooling down the surface and applying the second plasma treatment the surface is also well activated due to formation of oxygen-containing functional groups on the very surface [Fig.1d]. Due to the lower temperature of the second plasma treatment this activation remains sufficiently long for the following metallization-step.

An example of a system setup for polymer-matrix composite is presented in schematic Fig.2. The system consists of a vacuum pump 1, valve 2, a trap with sieves 3, a discharge chamber 7, two different leak valves 8 and two gas flasks 9 - oxygen and other (inert) gas, giving optimal etching rate. A first temperature chamber 10 is associated to the discharge chamber (reactor), the products treated in said temperature chamber 10 to the elevated first plasma treatment temperature at least on their surface being fed to the reactor 7 via conveyor 11. A second temperature chamber 12 is associated to the discharge chamber 7, the products, after the first plasma treatment step, being fed to the second temperature chamber 12 for cooling down at least on their surface and being subsequently fed back to the reactor for the second low-temperature plasma treatment via conveyor 13. Finally the system comprises a metallization chamber 14 of any suited type which is connected to the reactor via conveyor 15. Plasma parameters during etching process and the activation process like the dose of radicals in the discharge chamber are controlled by vacuum gauge 4 and two or more probes, such as catalytic probes 5 and Langmuir probes 6.

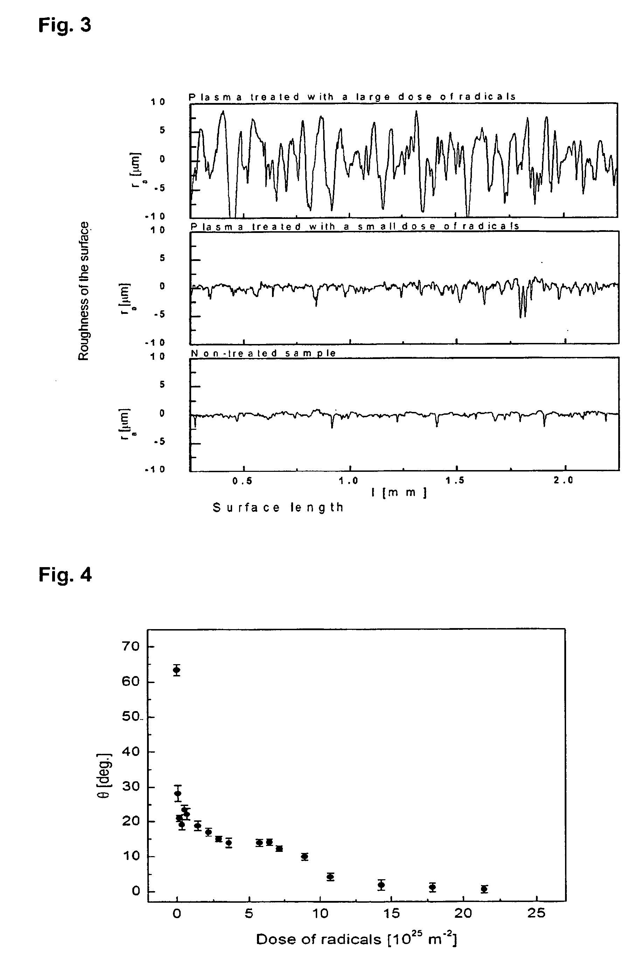

A higher flux of oxygen radicals increases surface roughness [Fig. 3]. This can be seen from the measurements of the roughness of the said sample surface in Fig. 3. The represented graphs give an idea about the roughness evolution from a non-treated (bottom) to plasma treated with a small dose of about 6·10²⁵ radicals per m² (middle) or plasma treated with a large dose at elevated temperature with about 15·10²⁵ radicals per m² (top). The elevated temperature helps in speeding up the process of surface roughening. There is a relation between the etching rate versus the dose of radicals and surface roughness evolution without externally increasing the temperature. The intense roughening starts at elevated temperatures at the dose of around 10²⁶ radicals per m², and is completed at the dose of around 2 · 10²⁶ radicals per m². Additional roughening is due to the etching effect since some clusters of fillings are removed.

Exposure to oxygen radicals also causes an activation of the polymer-matrix. The result of the incorporation of oxygen radicals into the composite surface is the surface energy increase, resulting in a better wettability. The example in Fig. 4 shows the wettability of the deionized water drop on the surface treated with a dose of radicals. Radicals may be incorporated into the surface layer of a composite causing formation of polar functional groups. This activation is carried out again by a second plasma treatment which is performed at a second treatment temperature below the first treatment temperature in order to provide a longer lasting activation of the surface.

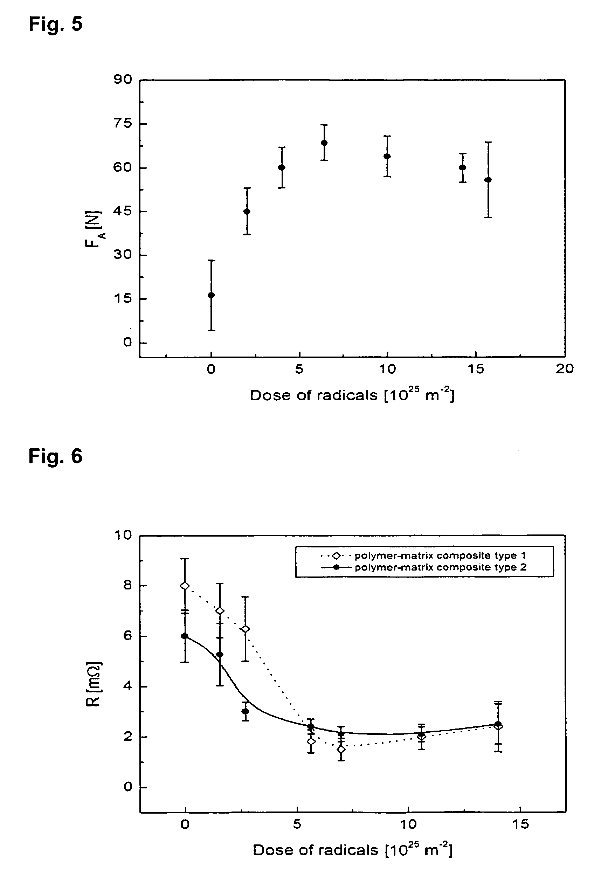

The appearance of highly polar groups on the composite surface causes an increase of the surface wettability and thus affinity to metallization. By producing higher roughness and wettability of the said composites, better affinity and higher adhesion of metallization is achieved. [Fig. 5] This substitutes wet chemical etching and a palladium chemisorption, which is the determinant step in metallization by the electroless process that allows establishing strong chemical bonds between the substrate and metallic film. The adhesion force of the named plasma-treated samples prior to Nickel (Ni) galvanic metallization is shown in the Fig. 5. This technological procedure used as a substitute for activation with palladium and deposition of chemical Ni, gives much better results. The adhesion force for the case of wet chemical etching of the said sample is 18.6 (±10.2)N, comparing to optimal plasma treatment where the adhesion force is 68.5 (±6)N.

Removal of the polymer increasing roughness and increased wettability of the said sample causes an improved electrical conductivity, too. [Fig. 6] The decrease of the electrical resistivity versus the radicals dose for two different polymer-matrix samples is shown in Fig. 6. The optimal electrical conductivity can be achieved by removing uppermost polymer between grains of better conducting fillings, and increase of surface roughness. In the presented samples this would be at the dose of 7·10²⁵ radicals per m², when the surface is free of polymer.

## Claims

1. Method for improving the electrical connection properties of the surface of a product made from a polymer-matrix composite comprising a filler, the method comprising the following steps:
- heating of the surface of the product to a first treatment temperature above the ambient temperature;
- first plasma treatment of the surface whereby removal of surface polymer and uncovering of filler is effected by oxygen radicals;
- cooling down of the plasma treated surface of the product to a second treatment temperature below the first treatment temperature;
- second plasma treatment of the surface created by the first plasma treatment whereby activation of the surface is effected by oxygen radicals;
- depositing a metallization on the surface created by the second plasma treatment.

2. Method according to claim 1
wherein the filler is sintered carbon or graphite.

3. Method according to claim 1, -
wherein the filler is a mixture including carbon or graphite.

4. Method according to claim 1,
wherein the first treatment temperature is between 20 and 150°C below the softening temperature of the polymer.

5. Method according to one of the claim 1 to 4,
wherein the first treatment temperature is between 0.7 and 1 times the softening temperature in Centigrade of the polymer.

6. Method according to one of the claims 1 to 5,
wherein the first treatment temperature is between 50 and 500°C.

7. Method according to claim 6,
wherein the first treatment temperature is between 80 and 400°C.

8. Method according to one of the claims 1 to 7,
wherein the second treatment temperature is chosen such that the deactivation time is at least 1 minute.

9. Method according to one of the claims 1 to 8,
wherein the second treatment temperature is less than 150°C.

10. Method according to claim 9,
wherein the second treatment temperature is less than 60°C.

11. Method according to claim 10,
wherein the second treatment temperature is less than 45°C.

12. Method according to one of the claims 1 to 11,
wherein the first and the second plasma treatment are performed in a pure oxygen atmosphere.

13. Method according to one of the claims 1 to 11,
wherein the first and the second plasma treatment are performed in an atmosphere of a mixture of oxygen and at least one noble gas.

14. Method according to claim 13,
wherein the first and the second plasma treatment are performed in an atmosphere of a mixture of oxygen and argon.

15. Method according to one of the claims 13 or 14,
wherein the oxygen content in the initial atmosphere is between 5 and 95% by volume.

16. Method according to one of the claims 1 to 15,
wherein the metallization is performed making use of a galvanic process.

17. Method according to one of the claims 1 to 15,
wherein the metallization is performed making use of a PVD process.

18. Method according to one of the claims 1 to 15,
wherein the metallization is performed making use of a PECVD process.

19. Method according to one of the claims 1 to 18,
wherein the time for exposing the surface to the second plasma treatment is much smaller than the time for exposing the surface to the first plasma treatment.

## Patentansprüche

1. Verfahren zum Verbessern der elektrischen Verbindungseigenschaften der Oberfläche eines Produkts aus einem Polymermatrix-Verbundwerkstoff, der einen Füllstoff umfasst, wobei das Verfahren die folgenden Schritte umfasst:
- Erwärmen der Oberfläche des Produkts auf eine erste Behandlungstemperatur oberhalb der Umgebungstemperatur;
- erste Plasmabehandlung der Oberfläche, wodurch ein Entfernen von Oberflächenpolymer und ein Freilegen von Füllstoff durch Sauerstoffradikale bewirkt wird;
- Abkühlen der plasmabehandelten Oberfläche des Produkts auf eine zweite Behandlungstemperatur unterhalb der ersten Behandlungstemperatur;
- zweite Plasmabehandlung der Oberfläche, die durch die erste Plasmabehandlung erzeugt wurde, wodurch eine Aktivierung der Oberfläche durch Sauerstoffradikale bewirkt wird;
- Abscheiden einer Metallisierung auf der Oberfläche, die durch die zweite Plasmabehandlung erzeugt wurde.

2. Verfahren nach Anspruch 1, wobei der Füllstoff gesinterter Kohlenstoff oder Graphit ist.

3. Verfahren nach Anspruch 1, wobei der Füllstoff ein Gemisch ist, das Kohlenstoff oder Graphit enthält.

4. Verfahren nach Anspruch 1, wobei die erste Behandlungstemperatur zwischen 20 und 150°C unterhalb der Erweichungstemperatur des Polymers liegt.

5. Verfahren nach einem der Ansprüche 1 bis 4, wobei die erste Behandlungstemperatur zwischen dem 0,7- und dem 1-fachen der Erweichungstemperatur in Grad Celsius des Polymers liegt.

6. Verfahren nach einem der Ansprüche 1 bis 5, wobei die erste Behandlungstemperatur zwischen 50 und 500°C liegt.

7. Verfahren nach Anspruch 6, wobei die erste Behandlungstemperatur zwischen 80 und 400°C liegt.

8. Verfahren nach einem der Ansprüche 1 bis 7, wobei die zweite Behandlungstemperatur so gewählt wird, dass die Deaktivierungszeit mindestens 1 Minute beträgt.

9. Verfahren nach einem der Ansprüche 1 bis 8, wobei die zweite Behandlungstemperatur niedriger als 150°C ist.

10. Verfahren nach Anspruch 9, wobei die zweite Behandlungstemperatur niedriger als 60°C ist.

11. Verfahren nach Anspruch 10, wobei die zweite Behandlungstemperatur niedriger als 45°C ist.

12. Verfahren nach einem der Ansprüche 1 bis 11, wobei die erste und die zweite Plasmabehandlung in einer reinen Sauerstoffatmosphäre ausgeführt werden.

13. Verfahren nach einem der Ansprüche 1 bis 11, wobei die erste und die zweite Plasmabehandlung in einer Atmosphäre eines Gemischs aus Sauerstoff und mindestens einem Edelgas ausgeführt werden.

14. Verfahren nach Anspruch 13, wobei die erste und die zweite Plasmabehandlung in einer Atmosphäre eines Gemischs aus Sauerstoff und Argon ausgeführt werden.

15. Verfahren nach einem der Ansprüche 13 oder 14, wobei der Sauerstoffgehalt in der Ausgangsatmosphäre zwischen 5 und 95 Volumen-% liegt.

16. Verfahren nach einem der Ansprüche 1 bis 15, wobei die Metallisierung unter Verwendung eines galvanischen Prozesses ausgeführt wird.

17. Verfahren nach einem der Ansprüche 1 bis 15, wobei die Metallisierung unter Verwendung eines PVD-Prozesses ausgeführt wird.

18. Verfahren nach einem der Ansprüche 1 bis 15, wobei die Metallisierung unter Verwendung eines PECVD-Prozesses ausgeführt wird.

19. Verfahren nach einem der Ansprüche 1 bis 18, wobei die Zeit des Inkontaktbringens der Oberfläche mit der zweiten Plasmabehandlung viel kürzer ist als die Zeit für das Inkontaktbringen der Oberfläche mit der ersten Plasmabehandlung.

## Revendications

1. Procédé permettant d'améliorer les propriétés de connexion électrique de la surface d'un objet fait d'un composite à matrice polymère comprenant une charge, le procédé comprenant les étapes suivantes :
- chauffer la surface de l'objet à une première température de traitement, supérieure à la température ambiante ;
- un premier traitement au plasma de la surface, dans lequel le retrait du polymère de surface et la mise à découvert de la charge sont effectués par des radicaux oxygène ;
- un refroidissement de la surface de l'objet traitée au plasma à une deuxième température de traitement inférieure à la première température de traitement ;
- un second traitement au plasma de la surface créée par le premier traitement au plasma, dans lequel l'activation de la surface est effectué par des radicaux oxygène ;
- déposer une métallisation sur la surface créée par le second traitement au plasma.

2. Procédé selon la revendication 1, dans lequel la charge est du carbone ou du graphite fritté.

3. Procédé selon la revendication 1, dans lequel la charge est un mélange incluant du carbone ou du graphite.

4. Procédé selon la revendication 1, dans lequel la première température de traitement est entre 20 et 150 °C en dessous de la température de ramollissement du polymère.

5. Procédé selon l'une des revendications 1 à 4, dans lequel la première température de traitement vaut entre 0,7 et 1 fois la température de ramollissement du polymère en centigrade.

6. Procédé selon l'une des revendications 1 à 5, dans lequel la première température de traitement est comprise entre 50 et 500 °C.

7. Procédé selon la revendication 6, dans lequel la première température de traitement est comprise entre 80 et 400 °C.

8. Procédé selon l'une des revendications 1 à 7, dans lequel la deuxième température de traitement est choisie de telle manière que le temps de désactivation est d'au moins une minute.

9. Procédé selon l'une des revendications 1 à 8, dans lequel la deuxième température de traitement est inférieure à 150 °C.

10. Procédé selon la revendication 9, dans lequel la deuxième température de traitement est inférieure à 60 °C.

11. Procédé selon la revendication 10, dans lequel la deuxième température de traitement est inférieure à 45 °C.

12. Procédé selon l'une des revendications 1 à 11, dans lequel les premier et second traitements au plasma sont exécutés dans une atmosphère d'oxygène pur.

13. Procédé selon l'une des revendications 1 à 11, dans lequel les premier et second traitements au plasma sont exécutés dans une atmosphère constituée d'un mélange d'oxygène et d'au moins un gaz noble.

14. Procédé selon la revendication 13, dans lequel les premier et second traitements au plasma sont exécutés dans une atmosphère constituée d'un mélange d'oxygène et d'argon.

15. Procédé selon l'une des revendications 13 et 14, dans lequel la teneur en oxygène dans l'atmosphère initiale est comprise entre 5 et 95 % en volume.

16. Procédé selon l'une des revendications 1 à 15, dans lequel la métallisation est effectuée en employant un processus galvanique.

17. Procédé selon l'une des revendications 1 à 15, dans lequel la métallisation est effectuée en employant un procédé de PVD.

18. Procédé selon l'une des revendications 1 à 15, dans lequel la métallisation est effectuée en employant un procédé de PECVD.

19. Procédé selon l'une des revendications 1 à 18, dans lequel le temps pour exposer la surface au second traitement au plasma est bien inférieur au temps pour exposer la surface au premier traitement au plasma.
